# EUROPÄISCHE PATENTSCHRIFT

(11) **EP 1 555 865 B1**
(45) Veröffentlichungstag und Bekanntmachung des Hinweises auf die Patenterteilung: **23.01.2008**
(21) Anmeldenummer: 04026065.5
(22) Anmeldetag: 03.11.2004
(51) Int. Cl.: H05K 7/02, H05K 5/00, H05K 7/14, H01R 4/18

(54) **Montage einer Sperrkreisanordnung mit diskreten, passiven elektronischen Bauteilen**
Assembly of a trap circuit with discrete, passive electronic components
Assemblage d'un circuit bouchon avec des composants électroniques discrets et passifs

(30) Priorität: 14.01.2004 DE 102004001899
(43) Veröffentlichungstag der Anmeldung: 20.07.2005
(73) Patentinhaber: MD Elektronik GmbH, 84478 Waldkraiburg (DE)
(72) Erfinder: Mayr, Josef, 84419 Schwindegg (DE); Friese, Norbert, 84574 Taufkirchen (DE)
(74) Vertreter: Hofmann, Ernst

(56) Entgegenhaltungen:
- EP-A- 0 762 549
- EP-A- 1 296 417
- DE-A1- 3 718 172
- DE-A1- 10 063 619
- DE-A1- 19 804 170
- US-A- 3 123 664
- US-A- 4 086 594
- US-B1- 6 491 528
- H.-J., LUDWIG: "Mechanische Aufbausysteme elektronischer Geräte" KONSTRUKTIVE GESTALTUNG UND FERTIGUNG IN DER ELEKTRONIK, BAND 2, 1983, Seiten 65-76, XP002327433
- PATENT ABSTRACTS OF JAPAN Bd. 009, Nr. 325 (E-368), 20. Dezember 1985 (1985-12-20) -& JP 60 158730 A (TOSHIBA KK), 20. August 1985 (1985-08-20)
- PATENT ABSTRACTS OF JAPAN Bd. 2003, Nr. 05, 12. Mai 2003 (2003-05-12) -& JP 2003 008322 A (ASAHI GLASS CO LTD), 10. Januar 2003 (2003-01-10)
- H., FREUTEL: "Verbindungstechnik elektronischer Geräte" KONSTRUKTIVE GESTALTUNG UND FERTIGUNG IN DER ELEKTRONIK, BAND 2, 1983, Seiten 77-89, XP002327434

## Beschreibung

Die Erfindung betrifft eine Sperrkreisanordnung mit einer Drosselspule und einem Kondensator, welche insbesondere zum Einbau in Kraftfahrzeugen geeignet ist, gemäß dem Oberbegriff des Anspruchs 1.

In modernen Kraftfahrzeugen werden nicht selten Drähte zum Beheizen von Heckscheiben gleichzeitig als Antenne zum Empfang von hochfrequenten Signalen genutzt. Damit beispielsweise Einschaltimpulse der Heckscheibenheizung nicht die Empfangssignale stören, werden häufig Drosselspulen mit entsprechender Induktivität und Kondensatoren in die Zuleitung eingebaut. Derartige Drosselspulen und Kondensatoren müssen in der Regel vor äußeren Einflüssen zur Vermeidung von Beschädigungen geschützt werden bzw. müssen mit einer elektrischen Isolierung versehen sein.

Zum Schutz der Drosselspulen und der Kondensatoren gegenüber der Umgebung sind diese bei bekannten Anordnungen beispielsweise von einem Schrumpfschlauch umgeben oder mit einer Kunstharzmasse vergossen. Darüber hinaus sind auch Bauweisen üblich, bei denen die Drosselspule in einem Gehäuse untergebracht sind.

In der EP 355 424 A2 ist eine Sperrkreisanordnung gezeigt, bei der die dazugehörigen elektrischen Bauteile auf einer Leiterplatte montiert sind. Diese Anordnung hat unter anderem den Nachteil, dass sie vergleichsweise empfindlich ist und beispielsweise im Zuge weiterer Herstellungsschritte leicht beschädigt werden kann.

Aus der JP 2000 013166 A2 ist eine Sperrkreisanordnung bekannt, bei der eine Drosselspule und zwei Kondensatoren in einem Gehäuse untergebracht sind. Eine derartige Sperrkreisanordnung ist relativ aufwändig herzustellen.

Die Patentschrift US 4 086 594 zeigt eine Sperrkreisanordnung für eine Antennenleitung, bestehend aus einer Drosselspule und zwei Kondensatoren ohne Erwähnung eines speziellen Aufbaus.

JP 2003 008322 A zeigt die Kontaktierung einer Drosselspule für eine Antennenleitung mit einem Kabel mittels Einstecken von Anschlussbereichen in Löcher einer Trägerplatte und Verlöten.

EP 1 296 417 A1 zeigt einen Steckverbinder für ein Airbag-System in dem ein Kabel durch einen Durchbruch in einer Trägerplatte hindurch mit einem Kontaktblech vercrimpt wird. Eine ebenfalls vorhandene Spule wird mit dem Kontaktblech verlötet.

Die bislang bekannten Ausführungen von Sperrkreisanordnungen mit einer Drosselspule und einem Kondensator, insbesondere solche, die in Kraftfahrzeugen eingesetzt werden, haben den unter anderem Nachteil, dass sie vergleichsweise aufwändig herzustellen oder zu montieren sind, oder dass deren mechanischer Aufbau bzw. die elektrischen Kontaktierungen anfällig gegenüber äußeren Störeinflüssen sind.

Der Erfindung liegt daher die Aufgabe zugrunde, eine Sperrkreisanordnung mit einem Gehäuse der eingangs genannten Art zu schaffen, welches die genannten Nachteile vermeidet, und insbesondere eine kostengünstige Montage bzw. einen technisch einfachen Zusammenbau erlaubt. Darüber hinaus soll eine hohe Zuverlässigkeit der Sperrkreisanordnung im Betrieb erreicht werden.

Diese Aufgabe wird erfindungsgemäß durch die Merkmale des Anspruches 1 gelöst.

Erfindungsgemäß weist die Sperrkreisanordnung eine Trägerplatte mit mindestens einem Durchbruch, welcher naturgemäß eine geometrische Fläche aufspannt, auf. Mindestens ein Anschlussbereich einer Drosselspule oder eines Kondensators ist dabei derart angeordnet, dass eine orthogonal zu dieser Fläche gerichtete und die Fläche durchdringende Gerade erzeugt werden kann, die diesen Anschlussbereich schneidet. Entsprechend befindet sich also zumindest ein Anschlussbereich im Bereich eines Durchbruchs, also zum Beispiel ober-, unter- oder innerhalb eines Durchbruchs.

Eine auf diese Weise gestaltete Trägerplatte hat bezüglich der Montage und der Funktion der Sperrkreisanordnung viele Vorteile. So können beispielsweise die elektrischen Bauteile, nämlich eine Drosselspule und ein oder mehrere Kondensatoren in den Trägerrahmen eingesetzt werden und mit einem Prozessschritt mit den entsprechenden Kabeln kontaktiert werden und im gleichen Prozessschritt mechanisch mit der Trägerplatte verbunden werden.

Wegen der guten Zugänglichkeit der Anschlussbereiche der elektrischen Bauteile können durch einfache Prozesse überaus zuverlässige elektrische Kontaktierungen ermöglicht werden, die Vibrationen und Erschütterungen ohne Einbußen in der Funktion dauerhaft standhalten.

In der Praxis hat es sich gezeigt, das es für einen störungsfreien Betrieb einer Sperrkreisanordnung wichtig ist, dass ein Mindestabstand zwischen der Drosselspule und dem Kondensator eingehalten werden muss. In einer bevorzugten Ausgestaltung der Erfindung sind die Drosselspule und ein Kondensator deshalb jeweils innerhalb eines Durchbruchs angeordnet und durch einen Steg voneinander getrennt. Dadurch wird auf einfache und wirksame Weise durch den Steg der Mindestabstand zwischen der Drosselspule und dem Kondensator, zur Vermeidung eines elektrischen Übersprechens, definiert.

Mit Vorteil werden die elektrischen Bauteile der Sperrkreisanordnung durch eine Crimpverbindung mit den entsprechenden elektrischen Leitern, die als Kabel ausgebildet sind, elektrisch kontaktiert. Speziell werden in diesem Zusammenhang Kontaktstreifen, beispielsweise Metallstreifen, bereichsweise zum Zwecke einer Crimpverbindung um ein Kabel im Anschlussbereich der elektrischen Bauteile plastisch verformt. In einer bevorzugten Ausgestaltung der Erfindung sind ein Anschlussbereich der Drosselspule und ein Anschlussbereich eines Kondensators durch ein und denselben Kontaktstreifen miteinander elektrisch verbunden. Dabei kann vorzugsweise ein Kontaktstreifen sowohl mit einem Anschlussbereich der Drosselspule, einem Anschlussbereich des Kondensators und einem Anschlussbereich eines zweiten Kondensators sowie eines Kabels in elektrischem Kontakt stehen.

Durch die spezielle Anordnung bzw. Ausrichtung der Anschlussbereiche bezüglich der Durchbrüche der Trägerplatte, sind die Anschlussbereiche für den Crimprozess von beiden Seiten her zugänglich, was erhebliche Vorteile für eine maschinelle Kontaktierung bei kurzen Taktzeiten bedeutet. Hinzu kommt, dass durch die gute Zugänglichkeit der Anschlussbereiche Kontaktierungen in bester Qualität erreichbar sind.

Alternativ dazu können die elektrischen Leiter, die als Kabel ausgebildet sind, auch durch einen Lötprozess mit den entsprechenden Anschlussbereichen der elektrischen Bauteile kontaktiert werden. Hier hat die Anordnung bzw. Ausrichtung der Anschlussbereiche bezüglich der Durchbrüche der Trägerplatte unter anderem den Vorteil, dass ein übermäßiger Wärmeeintrag und damit eine Beschädigung der Trägerplatte durch den Lötvorgang vermeiden werden kann.

Die mit der Erfindung erzielten Vorteile bestehen also insbesondere darin, dass eine entsprechende Sperrkreisanordnung qualitativ hochwertig kostengünstig herstellbar und montierbar ist. Insbesondere ist nach der Befestigung der elektrischen Bauteile auf der Trägerplatte ein vergleichsweise robustes Zwischenprodukt hergestellt worden, welches sicher handhabbar ist.

Vorteilhafte Ausbildungen der Erfindung entnimmt man den abhängigen Ansprüchen.

Weitere Einzelheiten und Vorteile der erfindungsgemäßen Sperrkreisanordnung ergeben sich aus der nachfolgenden Beschreibung eines Ausführungsbeispieles anhand der beiliegenden Figuren.

Es zeigen die
- Figur 1: eine perspektivische Ansicht der elektrischen Bauteile, nämlich einer Drosselspule, und zweier Kondensatoren der Sperrkreisanordnung,
- Figur 2: eine perspektivische Ansicht einer Trägerplatte,
- Figur 3: eine perspektivische Ansicht der Trägerplatte mit den montierten elektrischen Bauteilen und einem ersten Gehäuseteil,
- Figur 4: eine perspektivische Ansicht auf die Innenseite des ersten Gehäuseteils,
- Figur 5: eine perspektivische Ansicht auf die Innenseite eines zweiten Gehäuseteils,
- Figur 6: eine perspektivische Ansicht auf die Außenseite des zweiten Gehäuseteils.

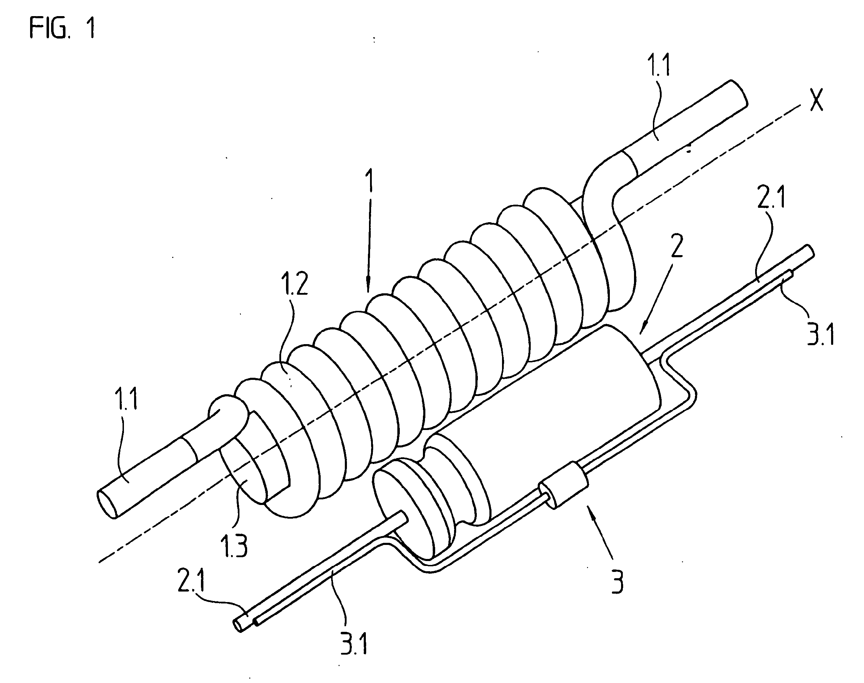

In der Figur 1 sind die elektrischen Bauteile der Sperrkreisanordnung gemäß dem Ausführungsbeispiel dargestellt.

Unter anderem zeigt die Figur 1 eine Ansicht einer Drosselspule 1, wie sie im vorgestellten Ausführungsbeispiel einer Sperrkreisanordnung in einer Antennenleitung eines Kraftfahrzeuges eingesetzt wird. Die Drosselspule 1 besteht aus einem mit Isolierlack versehenen Kupferdraht, welcher in einem großen Bereich der Drosselspule 1 entlang einer zylindrischen Schraubenlinie um die zentrale Achse X gebogen ist, so dass Windungen 1.2 der Drosselspule 1 wendelförmig ausgestaltet sind, bzw. der Windungsbereich eine wendelförmige Gestalt aufweist. Die Windungen 1.2 umschließen einen zylindrischen Eisenkern 1.3 und sind mit diesem zur mechanischen Befestigung verklebt. Ferner umfasst die Drosselspule 1, gemäß der Figur 1, zwei Anschlussbereiche 1.1, in denen der Kupferdraht vom Isolierlack befreit ist.

Ebenso umfasst die Sperrkreisanordnung gemäß der Figur 1 als weiteres elektrisches Bauteil einen ersten Kondensator, der im gezeigten Ausführungsbeispiel als ein Elektrolytkondensator 2 ausgebildet ist. Der Elektrolytkondensator 2 weist zwei Anschlussdrähte mit jeweils einem Anschlussbereich 2.1 auf.

Eine analoge Betrachtungsweise gilt auch für einen zweiten Kondensator der Sperrkreisanordnung, der im vorgestellten Ausführungsbeispiel ein Keramikkondensator 3 ist. Demnach befinden sich die Anschlussbereiche 3.1 des Keramikkondensators 3 an den entsprechenden Drähten, die aus dem Keramikkondensator 3 herausgeführt sind.

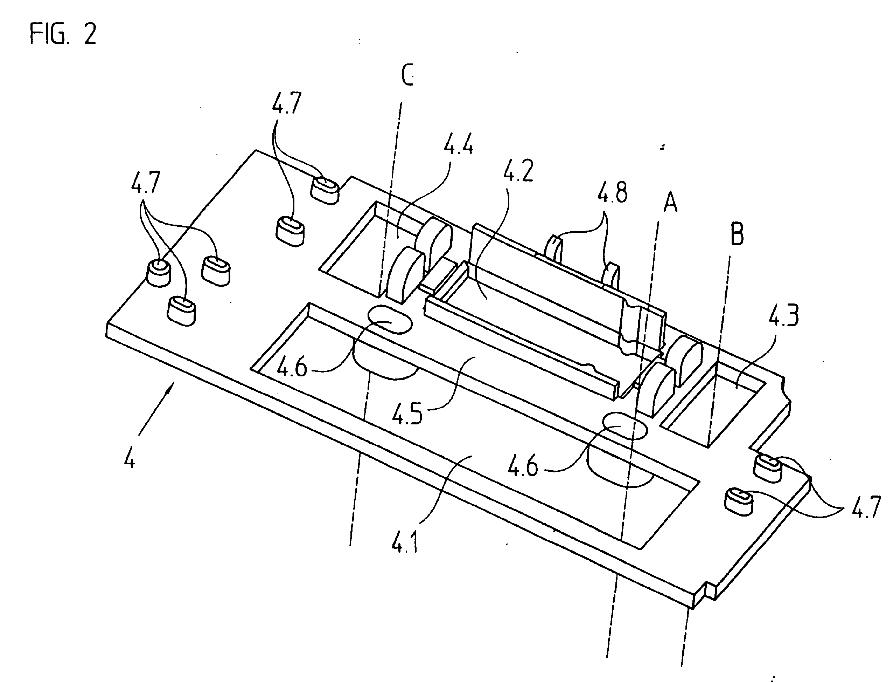

In der Figur 2 ist eine Trägerplatte 4 dargestellt, die als weiteres Bauteil der erfindungsgemäßen Sperrkreisanordnung dient. Die Trägerplatte 4 besteht aus einem Spritzgussteil aus elektrisch nicht leitendem thermoplastischem Kunststoff, und weist mehrere Durchbrüche 4.1, 4.2, 4.3, 4.4 auf. Die Durchbrüche 4.1, 4.2, 4.3, 4.4 spannen jeweils eine geometrische Fläche auf. Diese geometrische Fläche ist für jeden der Durchbrüche 4.1, 4.2, 4.3, 4.4 ein ebenes Rechteck, welches jeweils in der Ebene der Trägerplatte 4 zu liegen kommt. In der Figur 2 sind Geraden A, B, C eingezeichnet, welche orthogonal zu den von den Durchbrüchen 4.1, 4.3, 4.4 aufgespannten Flächen (Rechtecke) gerichtet sind, und die dazugehörigen Flächen (Rechtecke) durchdringen. Die Geraden A, B, C verlaufen also im gezeigten Ausführungsbeispiel allesamt parallel zueinander und sind außerdem orthogonal zur Ebene der Trägerplatte 4 gerichtet.

Darüber hinaus umfasst die Trägerplatte 4 Zentrierbohrungen 4.6, Noppen 4.7 und Haltesockel 4.8. Diese Elemente, sowie die Durchbrüche 4.1, 4.2, 4.3, 4.4 erfüllen für den Zusammenbau der Sperrkreisanordnung wichtige Aufgaben, wie weiter unten noch erläutert wird.

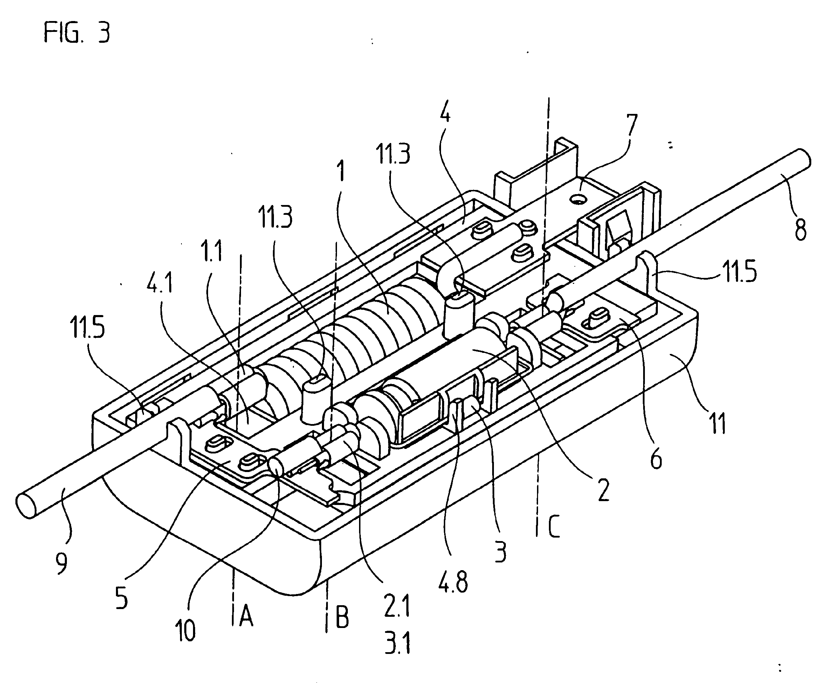

Bevor die elektrischen Bauteile in der Trägerplatte 4 montiert werden, wird an einem der Anschlussbereiche 1.1 der Drosselspule 1 durch ein Schweißverfahren eine Flachsteckerzunge 7 (siehe Figur 3), an welche später eine dazu passende Buchse aufgesteckt werden kann, elektrisch leitend befestigt.

Zur Vorbereitung der Montage der elektrischen Bauteile an die Trägerplatte 4 werden zunächst ein erster Metallstreifen 5 und ein zweiter Metallstreifen 6 auf die Trägerplatte 4 gesetzt (Figur 3). Dabei treten Noppen 4.7 durch entsprechende Löcher in den Metallstreifen 5, 6 hindurch, so dass ein exakte Platzierung, ohne langwierige Ausrichtung ermöglicht wird. Die elektrischleitenden Metallstreifen werden in diesem Herstellungsschritt als Bandmaterial von Rollen abgezogen. Sie haben in den Bereichen, die später für die Crimpverbindung verformt werden, eine im Wesentlichen V-förmige Gestalt.

Im Zuge des Zusammenbaus der Sperrkreisanordnung wird danach die Drosselspule 1 mit der Flachsteckerzunge 7 in die Ausnehmung 4.1 eingesetzt. Dabei durchdringen die drei Noppen 4.7 in der Verlängerung der Ausnehmung 4.1 entsprechende Löcher der Flachsteckerzunge 7. Auf diese Weise ist bereits in dieser Phase eine gewisse Positionsfixierung der Drosselspule 1 gegenüber der Trägerplatte 4 gegeben. Dabei ist die Achse X der Drosselspule 1 so ausgerichtet, dass diese eine Richtungskomponente parallel zur Ebene der Trägerplatte 4 aufweist, im gezeigten Beispiel ist die Achse X praktisch parallel zur Ebene der Trägerplatte 4. Der noch nicht durch die Flachsteckerzunge 7 kontaktierte Anschlussbereich 1.1 der Drosselspule 1 befindet sich nunmehr oberhalb des Durchbruchs 4.1 und liegt auf dem Metallstreifen 5 auf.

Analog hierzu wird der Elektrolytkondensator 2 in den Durchbruch 4.2 gesteckt. Jeder Anschlussdraht des Elektrolytkondensators 2 wird dabei zwischen einem Paar von Haltestegen fixiert, so dass sich die beiden Anschlussbereiche 2.1 des Elektrolytkondensators 2 oberhalb der Durchbrüche 4.3 bzw. 4.4 befinden. Die Anschlussbereiche 2.1 liegen dann gleichzeitig auf den entsprechenden V-förmigen Bereichen des ersten Metallstreifens 5 und des zweiten Metallstreifens 6 auf.

Der Keramikkondensator 3 wird nachfolgend mit seinen Drähten in die Haltesockel 4.8 eingelegt. Die Anschlussdrähte des Keramikkondensators 3 sind derart gebogen, dass die Anschlussbereiche 3.1 des Keramikkondensators 3 in der Nähe der Anschlussbereiche 2.1 des Elektrolytkondensators 2 zu liegen kommen. Demnach sind also die Anschlussbereiche 3.1 des Keramikkondensators 3 auch oberhalb der Durchbrüche 4.3 bzw. 4.4 angeordnet und liegen ebenso auf den V-förmigen Bereichen des ersten Metallstreifens 5 bzw. des zweiten Metallstreifens 6 auf.

Als nächstes wird die Trägerplatte 4 mit den beiden Metallstreifen 5, 6 und der Drosselspule 1, sowie dem Elektrolytkondensator 2 und dem Keramikkondensator 3 einer Crimpmaschine zugeführt. In der Crimpmaschine werden die beiden Metallstreifen 5, 6 bereichsweise, also dort, wo die Anschlussbereiche 1.1, 2.1, 3.1 aufliegen (V-förmige Bereiche), um jeweils ein Kabel 8, 9, 10 plastisch verformt. Insbesondere wird im vorgestellten Ausführungsbeispiel eine Rollcrimpung vorgenommen, wobei die Kabel 8, 9, 10 in der Crimpmaschine zugeführt werden. Vorliegend werden hier drei Crimpverbindungen gleichzeitig hergestellt. Das kurze Stück des Kabels 10 mit denen ein Anschlussbereich 2.1 des Elektrolytkondensators 2 und ein Anschlussbereich 3.1 des Keramikkondensators 3 in Kontakt gebracht werden hat im Übrigen lediglich die Aufgabe eine sichere Crimpverbindung durch dessen Elastizität bzw. Verformbarkeit an dieser Stelle zu ermöglichen.

In diesem Crimpschritt erweist sich die Anordnung mit der Trägerplatte 4 als besonders vorteilhaft. Zunächst, weil die Trägerplatte 4 eine exakte relative Positionierung der beiden Metallstreifen 5, 6, der Drosselspule 1, sowie dem Elektrolytkondensator 2 und dem Keramikkondensator 3 zueinander gewährleistet. Darüber hinaus kann durch Anschlagflächen die Trägerplatte 4 passgenau und schnell in der Crimpmaschine positioniert werden. Danach können sich die Crimpwerkzeuge bei den jeweiligen Anschlussbereichen 1.1, 2.1, 3.1 der Drosselspule 1, des Elektrolytkondensators 2 und des Keramikkondensators 3 von beiden Seiten der Trägerplatte 4 nähern und in die Durchbrüche 4.1, 4.3, 4.4 eintauchen. Dabei wird eine Einrollbewegung der beiden Metallsstreifen 5, 6 in den Anschlussbereichen 1.1, 2.1, 3.1 vorgenommen.

Gleichzeitig mit dem Crimpprozess wird auch eine mechanische Befestigung der beiden Metallstreifen 5, 6 an der Trägerplatte 4 vorgenommen. Zu diesem Zweck werden die Noppen 4.7 durch einen Stempel einer Druckkraft in Richtung der Mittelebene der Trägerplatte 4 ausgesetzt, so dass sich die Noppen 4.7 plastisch verformen. Demgemäß wird eine formschlüssige Verbindung der Metallstreifen 5, 6 mit der Trägerplatte 4 hergestellt.

Nach diesen in einer einzigen Fertigungsmaschine nahezu gleichzeitig ablaufenden Arbeitsschritten ist nach kurzer Bearbeitungszeit eine kompakte Einheit aus Trägerplatte 4, elektrischen Bauteilen und Kabeln 8, 9 hergestellt. Diese Einheit kann sicher vorgefertigt, gelagert und transportiert werden.

Als nächster Herstellungsschritt folgt die Montage der vormontierten Trägerplatte 4 auf ein erstes Gehäuseteil 11, gemäß der Figur 3. Zu diesem Zweck wird die vormontierte Trägerplatte 4 in das erste Gehäuseteil 11 eingelegt und die Kabel 8, 9 in Kabelclips 11.5 des ersten Gehäuseteils 11 eingedrückt.

In der Figur 3 ist auch zu sehen, dass der Anschlussbereich 1.1 der Drosselspule 1 derart angeordnet ist, dass die Gerade A diesen Anschlussbereich 1.1 schneidet. Die gleichen Betrachtungen gelten für die Geraden B und C,, welche die Anschlussbereiche 2.1 des Elektrolytkondensators 2 bzw. die Anschlussbereiche 2.1 des Keramikkondensators 3 schneiden und gleichzeitig die dazugehörigen Durchbrüche 4.3, 4.4 (bzw. die von den Durchbrüchen 4.3, 4.4 aufgespannten Flächen, insbesondere Rechtecke) durchdringen. Dieser geometrische Zusammenhang gewährleistet die gute Zugänglichkeit der Crimpwerkzeuge zu den Anschlussbereichen 1.1 2.1, so dass dadurch eine qualitativ hochwertige und robuste Kontaktierung bei minimalen Fertigungszeiten möglich ist. Im gezeigten Ausführungsbeispiel fallen im Übrigen die Anschlussbereiche 2.1 des Elektrolytkondensators 2 und die Anschlussbereiche 3.1 des Keramikkondensators 3 weitgehend zusammen.

Aus der Figur 3 ist weiterhin ersichtlich, dass der Metallstreifen 5 sowohl mit dem Anschlussbereich 1.1 der Drosselspule 1, dem Anschlussbereich 2.1 des Elektrolytkondensators 2 und dem Anschlussbereich 3.1 des Keramikkondensators 3 sowie dem Kabel 9 in elektrischem Kontakt steht. Auf diese Weise ist mit minimalem Material- und Herstellungsaufwand eine elektrische Kontaktierung dieser Teile erreicht worden.

Für eine gute und sichere Funktion der Sperrkreisanordnung ist es wichtig, dass ein elektrisches Übersprechen zwischen der Drosselspule 1 und dem der Drosselspule 1 benachbart angeordneten Kondensator, hier der Elektrolytkondensator 2, vermieden wird. Es hat sich nunmehr gezeigt, dass zu diesem Zweck ein Mindestabstand zwischen den beteiligten elektrischen Bauteilen eingehalten werden muss. Dieser Mindestabstand zwischen der Drosselspule 1 und dem Elektrolytkondensator 2 wird durch die Breite des Stegs 4.5 definiert, da die Drosselspule 1 und der Elektrolytkondensator 2 innerhalb der Durchbrüche 4.1, 4.2 angeordnet sind. Auf diese Weise ist sichergestellt, dass auch während oder nach Vibrationen und Stößen, wie sie im Betrieb einer derartigen Sperrkreisanordnung in Kraftfahrzeugen üblich sind, stets der Mindestabstand gewahrt bleibt.

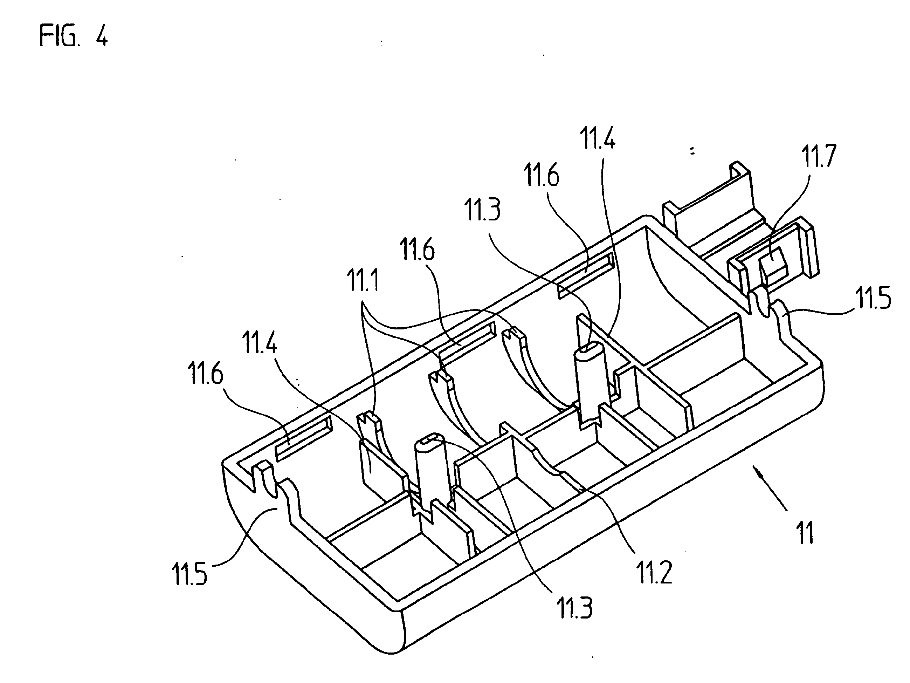

Zur Vibrationsunempfindlichkeit der Sperrkreisanordnung trägt auch die Gestaltung des ersten Gehäuseteils 11 bei. Eine perspektivische Ansicht gemäß der Figur 4 zeigt im Wesentlichen die Innenseite des ersten Gehäuseteils, 11. Zur Fixierung der Drosselspule 1 und des Elektrolytkondensators 2 sind dort mehrere Stege 11.1, 11.2, 11.4 vorgesehen. Dabei sollen die Stege 11.4 die Drosselspule 1 gegen Verschiebungen in Richtung ihrer Achse X sichern. Der Steg 11.2 ist vorgesehen, um den Elektrolytkondensator 2 radial zu sichern. Analog dazu können die Stege 11.1 die Drosselspule 1 radial stützen.

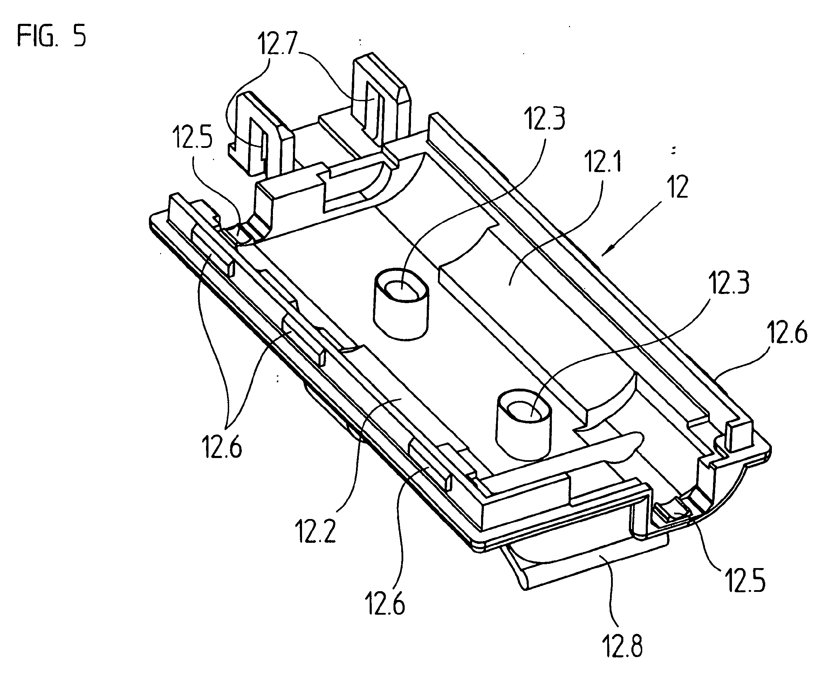

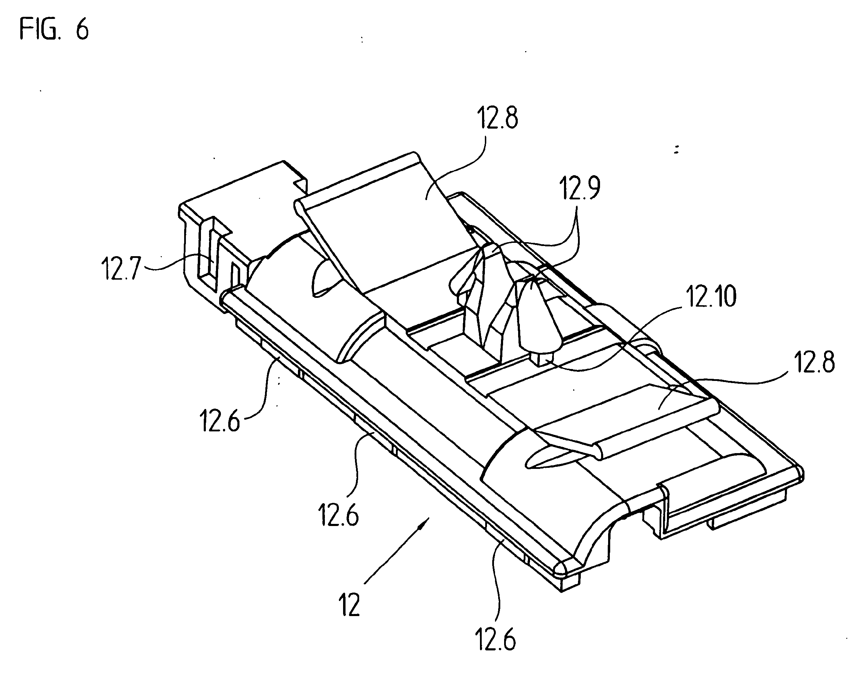

Damit bezüglich der Drosselspule 1 und des Elektrolytkondensators 2 radial gerichtete Kräfte aufgebracht werden können, bedarf es einer Reaktionskraft, welche durch ein zweites Gehäuseteil 12 eingeleitet wird (siehe die Figuren 5, 6). Es sind hierfür im ersten Gehäuseteil 11 sechs Clip-Ausnehmungen 11.6 und zwei Clip-Vorsprünge 11.7 vorgesehen, welche eine Clip-Verbindung zum zweiten Gehäuseteil 12 ermöglichen.

Gemäß der Figur 5 sind am zweiten Gehäuseteil 12 Clip-Vorsprünge 12.6 und Clip-Fenster 12.7 angeordnet, welche wirksam mit den entsprechenden Clip-Ausnehmungen 11.6 und Clip-Vorsprüngen 11.7 zum mechanischen Verbinden der beiden Gehäuseteile 11, 12 verwendet werden. Die Drosselspule 1, der Elektrolytkondensator 2, der Keramikkondensator 3 und die Trägerplatte 4 sind dann also von einem Gehäuse eingeschlossen, welches aus den beiden Gehäuseteilen 11, 12 besteht. Die beiden Gehäuseteile 11, 12 sind dabei so dimensioniert, dass der Steg 11.2 bzw. die Stege 11.1 den Elektrolytkondensator 2 bzw. die Drosselspule 1 spielfrei und vorgespannt gegen Auflageflächen 12.1 bzw. 12.2 an der Innenseite des zweiten Gehäuseteils 12 drücken, wenn die Gehäuseteile 11, 12 zusammengeclipt sind. Auf diese Weise wird eine überaus vibrationsunempfindliche Sperrkreisanordnung geschaffen, wobei eine Geräuschentwicklung, wie z. B. ein Klappern, der Sperrkreisanordnung während des Betriebs eines Kraftfahrzeuges, in das die Sperrkreisanordnung eingebaut ist, vermieden wird.

Darüber hinaus wird durch die Stege 11.1, 11.2, 11.4 sowie den Auflageflächen 12.1 bzw. 12.2 die relative Lage zwischen der Drosselspule 1, dem Elektrolytkondensator 2 weiterhin fixiert. Das heißt, dass also die Innenseite des Gehäuseteils 11 derart ausgestaltet ist, dass diese die Drosselspule 1 gegen das zweite Gehäuseteil 12 und die Trägeplatte 4 drückt, so dass ein spielfreier Einbau der Drosselspule 1 erreicht wird und die relative Lage zwischen der Drosselspule 1 und dem Elektrolytkondensator 2 fixiert wird.

Das zweite Gehäuseteil 12 weist darüber hinaus auch noch Kabelklemmflächen 12.5 auf, durch welche die Kabel 8, 9 am Durchtritt durch das Gehäuse spielfrei fixiert werden. An der Innenseite des zweiten Gehäuseteils 12 befinden sich zwei Zapfen, welche Zentrieröffnungen 12.3 aufweisen. Diese Zentrieröffnungen 12.3 sind zur Aufnahme der Zentrierstifte 11.3 des ersten Gehäuseteils 11 vorgesehen, so dass eine einfache und passgenaue Montage des zweiten Gehäuseteils 12 an eine Anordnung in einer Herstellungsphase gemäß der Figur 3 möglich ist. Im gezeigten Ausführungsbeispiel sind im Übrigen die Gehäuseteile 11, 12 aus elektrisch nicht-leitendem Material, nämlich aus einem Polymer, mit Hilfe eines Spritzgussverfahrens hergestellt.

Zur exakten relativen Positionierung des ersten Gehäuseteils 11, der Trägerplatte 4 und des zweiten Gehäuseteils 12 weist das erste Gehäuseteil 11 die Zentrierstifte 11.3 auf, die, wie in der Figur 3 gezeigt, eine Zentrierbohrung 4.6 in der Trägerplatte 4 durchdringt und in eine Öffnung 12.3 (siehe Figur 5) des zweiten Gehäuseteils 12. ragt.

An der Außenseite des zweiten Gehäuseteils 12 befinden sich, gemäß der Figur 6, zwei Federstege 12.8 und ein Clip-Element 12.9, welches zwei Zapfen 12.10 aufweist. Wenn nun die Sperrkreisanordnung mit den zusammengeclipten Gehäuseteilen 11, 12 entsprechend hergestellt ist, kann konstruktionsbedingt eine einfache Befestigung der Sperrkreisanordnung, beispielsweise in einem Kraftfahrzeug an einem Metall oder einem Kunststoffteil als Anbaufläche vorgenommen werden. Hierfür ist in der Anbaufläche ein Langloch vorbereitet. In dieses Langloch wird das Clip-Element 12.9 eingeschoben, wobei das Gehäuse so ausgerichtet ist, dass sich die längere Achse des Langloches in X-Richtung erstreckt. Dabei werden die Clip-Haken des Clip-Elements 12.9 in X-Richtung elastisch zusammengedrückt bzw. verformt. Die Zapfen 12.10 rasten im Langloch ein und gleichzeitig werden die Federstege 12.8 elastisch gebogen. Den Kräften der Federstege 12.8 wirken die Reaktionskräfte infolge des Hinterfassens des Clip-Elements 12.9 entgegen. Auf diese Weise ist an der Anbaufläche eine vorgespannte Befestigung der Sperrkreisanordnung geschaffen.

Die Montage der Sperrkreisanordnung an die Anbaufläche kann also in überaus kurzer Zeit ohne die Verwendung eines Werkzeugs erfolgen, wobei sich das Gehäuse achsparallel zur Längsrichtung des Langloches selbstständig ausrichtet.

Die Länge der Zapfen 12.10 ist so dimensioniert, dass sie größer ist als die Stärke des als Anbaufläche verwendeten Metalls, so dass nach erfolgter Montage der Sperrkreisanordnung die Zapfen 12.10 über die entsprechende Oberfläche des Metalls herausragen. Dieser Überstand kann als Angriffsfläche für eine Zange dienen, durch welche im Zuge einer Demontage der Sperrkreisanordnung von der Anbaufläche das Clip-Element 12.9 wieder zusammengedrückt werden kann.

## Patentansprüche

1. Sperrkreisanordnung für eine Antennenleitung, wobei die Sperrkreisanordnung
· mindestens zwei elektrische Bauteile aufweist, nämlich eine Drosselspule (1) und mindestens einen Kondensator (2), wobei zumindest eines der elektrischen Bauteile mindestens einen Anschlussbereich (1.1, 2.1) aufweist, und dieser Anschlussbereich (1.1, 2.1) mit einem elektrischen Leiter (8, 9, 10) kontaktiert ist,
**dadurch gekennzeichnet, dass**
· der elektrische Leiter (8, 9, 10) als ein Kabel ausgebildet ist, und die Sperrkreisanordnung weiterhin
· eine Trägerplatte (4) umfasst, welche mindestens einen Durchbruch (4.1, 4.3, 4.4) aufweist, welcher eine geometrische Fläche aufspannt, wobei der mindestens eine Anschlussbereich (1.1, 2.1) derart angeordnet ist, dass eine orthogonal zur Fläche gerichtete und die Fläche durchdringende Gerade (A, B, C) erzeugbar ist, die den Anschlussbereich (1.1, 2.1) schneidet, um durch diese spezielle Anordnung bezüglich des Durchbruchs (4.1, 4.3, 4.4) und dessen Dimensionierung zu erreichen, dass die Kontaktierung des Anschlussbereichs (1.1, 2.1) mit dem Kabel durch Crimpen durchführbar ist und der Anschlussbereich (1.1, 2.1) für Werkzeuge zum Durchführen des Crimprozesses von beiden Seiten der Trägerplatte (4) her gut zugänglich ist.

2. Sperrkreisanordnung gemäß dem Anspruch 1, **dadurch gekennzeichnet, dass** die Drosselspule (1) und der Kondensator (2) jeweils innerhalb eines Durchbruchs (4.1, 4.2) angeordnet und durch einen Steg (4.5) voneinander getrennt sind, so dass durch den Steg (4.5) der Mindestabstand zwischen der Drosselspule (1) und dem Kondensator (2), zur Vermeidung eines elektrischen Übersprechens, definiert wird.

3. Sperrkreisanordnung gemäß dem Anspruch 1 oder 2, **dadurch gekennzeichnet, dass** die Drosselspule (1) eine wendelförmige Windung (1.2) um eine Achse (X) aufweist, wobei die Achse (X) so ausgerichtet ist, dass diese eine Richtungskomponente parallel zur Ebene der Trägerplatte (4) aufweist.

4. Sperrkreisanordnung gemäß einem der vorhergehenden Ansprüche, **dadurch gekennzeichnet, dass** ein Kontaktstreifen (5, 6) vorgesehen ist, und dieser bereichsweise zum Zwecke einer Crimpverbindung um das Kabel (8, 9, 10) im Anschlussbereich (1.1, 2.1, 3.1) des elektrischen Bauteils das einen Anschlussbereich aufweist plastisch verformt ist.

5. Sperrkreisanordnung gemäß dem Anspruch 4, **dadurch gekennzeichnet, dass** sowohl die Drosselspule (1) als auch der Kondensator (2) einen Anschlussbereich aufweisen und dass der Anschlussbereich (1.1) der Drosselspule (1) und der Anschlussbereich (2.1) des Kondensators (2) durch den Kontaktstreifen (5) miteinander elektrisch verbunden sind.

6. Sperrkreisanordnung gemäß dem Anspruch 5, **dadurch gekennzeichnet, dass** ein zweiter Kondensator (3) mit einem Anschlussbereich vorgesehen ist und dass der Kontaktstreifen (5) sowohl mit dem Anschlussbereich (1.1) der Drosselspule (1), dem Anschlussbereich (2.1) des Kondensators (2) und dem Anschlussbereich (3.1) des zweiten Kondensators (3) und dem Kabel (9) in elektrischem Kontakt steht.

7. Sperrkreisanordnung gemäß einem der vorhergehenden Ansprüche, **dadurch gekennzeichnet, dass** ein Gehäuse bestehend aus mehreren Gehäuseteilen (11, 12) vorgesehen ist und dass die Drosselspule (1), der Kondensator (2), und die Trägerplatte (4) von diesem Gehäuse eingeschlossen sind.

8. Sperrkreisanordnung gemäß dem Anspruch 7, **dadurch gekennzeichnet, dass** die Innenseite von zumindest einem Gehäuseteil (11, 12) derart ausgestaltet ist, dass diese zumindest eines der elektrischen Bauteile gegen ein weiteres Gehäuseteil (11, 12) oder die Trägeplatte (4) drückt, so dass ein spielfreier Einbau des zumindest einen elektrischen Bauteils erreicht wird und die relative Lage zwischen der Drosselspule (1) und dem Kondensator (2) fixiert wird.

9. Sperrkreisanordnung gemäß dem Anspruch 7, **dadurch gekennzeichnet, dass** Stege (11.1, 11.2) in einem Gehäuseteil (11) vorgesehen sind und diese zumindest ein elektrisches Bauteil gegen eine Auflagefläche (12.1, 12.2) eines anderen Gehäuseteils (12) drücken.

10. Sperrkreisanordnung gemäß einem der Ansprüche 7, 8, oder 9, **dadurch gekennzeichnet, dass** eine Clip-Verbindung (11.6, 12.6; 11.7, 12.7) vorgesehen ist durch die die Gehäuseteile (11, 12) zusammengehalten werden.

11. Sperrkreisanordnung gemäß einem der Ansprüche 7, 8, 9, oder 10, **dadurch gekennzeichnet, dass** zur exakten relativen Positionierung eines ersten Gehäuseteils (11), der Trägerplatte (4) und eines zweiten Gehäuseteils (12) das erste Gehäuseteil (11) mindestens einen Zentrierstift (11.3) die Trägerplatte (4) eine Zentrierbohrung (4.6) und das zweite Gehäuseteil (12) eine Öffnung (12.3) aufweist, und der Zentrierstift die Zentrierbohrung (4.6) durchdringt und in die Öffnung (12.3) ragt.

## Claims

1. Trap circuit arrangement for an antenna line, the trap circuit arrangement
- having at least two electrical components, namely an inductance coil (1) and at least one condenser (2), at least one of the electrical components having at least one connection region (1.1, 2.1), and this connection region (1.1, 2.1) being able to be contacted with an electrical conductor (8, 9, 10),
**characterised in that**
- the electrical conductor (8, 9, 10) is configured as a cable, and in addition the trap circuit arrangement
- including a carrier plate (4) which has at least one through-opening (4.1, 4.3, 4.4) which spans a geometric surface, the at least one connection region (1.1, 2.1) being disposed such that a straight line (A, B, C) which is directed orthogonally to the surface and penetrates the surface can be produced, said straight line intersecting the connection region (1.1, 2.1) in order to achieve, by this special arrangement relative to the through-opening (4.1, 4.3, 4.4) and the dimensioning thereof, that contacting of the connection region (1.1, 2.1) to the cable can be implemented by crimping, and the connection region (1.1, 2.1) is readily accessible for tools in order to implement the crimping process from both sides of the carrier plate (4).

2. Trap circuit arrangement according to claim 1, **characterised in that** the inductance coil (1) and the condenser (2) are disposed respectively within a through-opening (4.1, 4.2) and are separated from each other by a web (4.5) so that the minimum spacing between the induction coil (1) and the condenser (2) is defined by the web (4.5), in order to avoid electrical crosstalk.

3. Trap circuit arrangement according to claim 1 or 2, **characterised in that** the induction coil (1) has a spiral-shaped winding (1.2) about an axis (X), the axis (X) being aligned such that the latter has a directional component which is parallel to the plane of the carrier plate (4).

4. Trap circuit arrangement according to one of the preceding claims, **characterised in that** a contact strip (5, 6) is provided, and in regions the latter is plastically deformed for the purpose of a crimping connection about the cable (8, 9, 10) in the connection region (1.1, 2.1, 3.1) of the electrical component which has a connection region.

5. Trap circuit arrangement according to claim 4, **characterised in that** both the induction coil (1) and the condenser (2) have a connection region and **in that** the connection region (1.1) of the induction coil (1) and the connection region (2.1) of the condenser (2) are connected to each other electrically by the contact strip (5).

6. Trap circuit arrangement according to claim 5, **characterised in that** a second condenser (3) is provided with a connection region and **in that** the contact strip (5) is connected electrically both to the connection region (1.1) of the induction coil (1), to the connection region (2.1) of the condenser (2) and to the connection region (3.1) of the second condenser (3) and to the cable (9).

7. Trap circuit arrangement according to one of the preceding claims, **characterised in that** a housing comprising a plurality of housing parts (11, 12) is provided and **in that** the induction coil (1), the condenser (2) and the carrier plate (4) are enclosed by this housing.

8. Trap circuit arrangement according to claim 7, **characterised in that** the interior of at least one housing part (11, 12) is configured in such a way that the latter presses at least one of the electrical components against a further housing part (11, 12) or the carrier plate (4), so that clearance-free assembly of the at least one electrical component is achieved and the relative position between the induction coil (1) and the condenser (2) is fixed.

9. Trap circuit arrangement according to claim 7, **characterised in that** webs (11.1, 11.2) are provided in a housing part (11) and said webs press at least one electrical component against a support surface (12.1, 12.2) of another housing part (12).

10. Trap circuit arrangement according to one of the claims 7, 8 or 9, **characterised in that** a clip connection (11.6, 12.6; 11.7, 12.7) is provided by means of which the housing parts (11, 12) are held together.

11. Trap circuit arrangement according to one of the claims 7, 8, 9 or 10, **characterised in that,** for exact relative positioning of a first housing part (11), of the carrier plate (4) and of a second housing part (12), the first housing part (11) has at least one centring pin (11.3), the carrier plate (4) has a centring boring (4.6) and the second housing part (12) has an opening (12.3), and the centring pin penetrates the centring boring (4.6) and protrudes into the opening (12.3).

## Revendications

1. Assemblage d'un circuit bouchon pour une ligne d'antenne, qui comprend au moins deux composants électriques, à savoir une bobine d'arrêt (1) et au moins un condensateur (2), avec sur au moins un de ces composants électriques, une zone de raccordement (1.1, 2.1) qui est en contact avec un conducteur électrique (8, 9, 10),
cet assemblage présentant les caractéristiques suivantes :
- le conducteur électrique (8, 9, 10) est constitué par un câble,
- il comprend une plaque porteuse (4) avec un passage (4.1, 4.3, 4.4) définissant une surface géométrique, et la zone de raccordement (1.1, 2.1) au nombre d'une au moins est disposée de manière que peut être définie une droite (A, B, C) qui est perpendiculaire à cette surface, la traverse et coupe la zone de raccordement (1.1, 2.1) de manière à, par cet assemblage spécifique par rapport au passage (4.1, 4.3, 4.4) et par le dimensionnement de celui-ci, pouvoir réaliser par sertissage le contact de la zone de raccordement (1.1, 2.1) avec le câble, avec une bonne accessibilité des deux côtés de la plaque porteuse (4), à la zone de raccordement (1.1, 2.1) pour des outils servant à réaliser le processus de sertissage.

2. Assemblage d'un circuit bouchon selon la revendication 1, **caractérisé en ce que** la bobine d'arrêt (1) et le condensateur (2) sont disposés tous deux dans le passage (4.1, 4.2) en étant séparés l'un de l'autre par une barrette (4.5) qui définit entre la bobine d'arrêt (1) et le condensateur (2) la distance minimale nécessaire pour éviter une diaphonie entre réel et réel.

3. Assemblage d'un circuit bouchon selon la revendication 1 ou 2, **caractérisé en ce que** la bobine d'arrêt (1) présente un enroulement (1.2) hélicoïdal autour d'un axe qui est orienté de manière à présenter une composante directionnelle parallèle au plan de la plaque porteuse (4).

4. Assemblage d'un circuit bouchon selon une des revendications précédentes, **caractérisé en ce qu'**il est prévu une bande de contact (5, 6) qui localement, afin de réaliser une liaison sertie autour du câble (8, 9, 10), est déformée plastiquement dans la zone de raccordement (1.1, 2.1, 3.1) du composant électrique qui présente une zone de raccordement.

5. Assemblage d'un circuit bouchon selon la revendication 4, **caractérisé en ce que** la bobine d'arrêt (1) ainsi que le condensateur (2) présentent une zone de raccordement, les zones de raccordement (1.1, 2.1) de la bobine d'arrêt (1) et du condensateur (2) respectivement étant reliées électriquement par une bande de contact (5).

6. Assemblage d'un circuit bouchon selon la revendication 5, **caractérisé en ce qu'**il est prévu un second condensateur (3) avec une zone de raccordement, la bande de contact (5) étant en contact électrique à la fois avec la zone de raccordement (1.1) de la bobine d'arrêt (1), la zone de raccordement (2.1) du condensateur (2) et la zone de raccordement (3.1 du second condensateur (3).

7. Assemblage d'un circuit bouchon selon une des revendications précédentes, **caractérisé en ce qu'**il est prévu un boîtier en plusieurs parties (11, 12), la bobine d'arrêt (1) du condensateur (2) ainsi que la plaque porteuse (4) étant enfermées dans ce boîtier.

8. Assemblage d'un circuit bouchon selon la revendication 7, **caractérisé en ce que** la face interne d'au moins une partie de boîtier (11, 12) est configurée de manière à appliquer au moins un des composants électriques sur l'autre partie de boîtier (11, 12) ou sur la plaque porteuse (4), et qu'ainsi le montage sans jeu d'au moins un composant électrique est obtenu et également la position relative de la bobine d'arrêt (1) et du condensateur (2) est fixée.

9. Assemblage d'un circuit bouchon selon la revendication 7, **caractérisé en ce que** les barrettes (11.1, 11.2) sont prévues dans une partie de boîtier (11) et que ces barrettes appliquent au moins un composant électrique sur une portée d'appui (12.1, 12.2) de l'autre partie de boîtier (12).

10. Assemblage d'un circuit bouchon selon une des revendications 7, 8, 9, **caractérisé en ce qu'**il est prévu une liaison clipsée (11.6, 12.6 ; 11.7, 12.7) par laquelle sont assemblées les parties de boîtier (11, 12).

11. Assemblage d'un circuit bouchon selon une des revendications 7, 8, 9, 10 **caractérisé en ce que** pour assurer le positionnement relatif exact d'une première partie de boîtier (11), de la plaque porteuse (4) et de la seconde partie de boîtier (12), la première partie de boîtier (11) présente au moins une broche de centrage (11.3), la plaque porteuse (4) un alésage de centrage (4.6) et la seconde partie de boîtier (12) une ouverture (12.3), la broche de centrage traversant l'alésage de centrage (4.6) et faisant saillie à travers l'ouverture (12.3).
